# EUROPEAN PATENT APPLICATION

(11) **EP 3 579 269 A1**
(43) Date of publication of application: **11.12.2019**
(21) Application number: 18747717.9
(22) Date of filing: 30.01.2018
(51) Int. Cl.: H01L 23/36, C01B 32/205, C09J 7/20, C09J 133/00, C09J 163/00, C09J 183/04, C09J 201/00, H01L 23/373, H05K 7/20

(54) **THERMAL INTERFACE MATERIAL, INTERFACE THERMAL COUPLING METHOD, AND PRODUCTION METHOD FOR THERMAL INTERFACE MATERIAL**

(30) Priority: 02.02.2017 JP 2017017696
(71) Applicant: Kaneka Corporation, Osaka-shi, Osaka 530-8288 (JP)
(72) Inventor: MURAKAMI, Mutsuaki, Settsu-shi Osaka 566-0072 (JP); TATAMI, Atsushi, Settsu-shi Osaka 566-0072 (JP); TACHIBANA, Masamitsu, Settsu-shi Osaka 566-0072 (JP)
(74) Representative: Hoffmann Eitle
(86) International application number: PCT/JP2018/002956
(87) International publication number: WO 2018/143189

(57) **Abstract**

An object of the present invention is to provide a thermal interface material made of a graphite film having excellent thermal resistance even when interposed between materials having unevenness, and a method for preparing the thermal interface material. The above object is solved by the thermal interface material containing a graphite film and a fluid substance, wherein the graphite film has a thickness of 100 nm to 15 µm, a density of 1.20 g/cm³ to 2.26 g/cm³, a thermal conductivity of 500 W/mK to 2000 W/mK in a film plane direction, and a weight ratio of the fluid substance to the graphite film is 0.08 to 25.

## Description

### TECHNICAL FIELD

The present invention relates to a thermal interface material for rapidly transferring heat from a heat generation source to a cooling material or a heat radiating material, a method for thermally coupling with the thermal interface material, and a method for preparing the thermal interface material.

### BACKGROUND ART

In recent years, heat in electronic devices and in LED (Light Emitting Diode) illumination is great problems to be solved. For heat dissipation and cooling, there are many methods such as thermal conductions, thermal radiations, or heat convections. In order to effectively dissipate or cool the heat from a heat generation source, there is a need to combine these heat-dissipating and cooling methods so that the heat from a heat generating material may be efficiently transferred to a heat-dissipating and cooling material such as a circuit substrate, a cooling fin, a heat sink, or the like. For that purpose, it is important to reduce the thermal resistance between the heat generating material and the heat-dissipating and cooling material.

When the hard materials such as a metal and a ceramic are simply coupled with each other, the coupling between the hard materials only forms point contacts due to the unevennesses on the surfaces of both the hard materials. As a result, a thermal resistance becomes large due to the existence of an air layer having a low thermal conductivity (thermal conductivity: 0.02 W/mK) between the hard materials. In order to lower such thermal resistance between the hard materials, a thermal interface material (Thermal Interface Material, hereafter abbreviated as TIM) is interposed between materials such as between metals or between a metal and a ceramic. Therefore, the decrease of the thermal resistance requires high thermal conductivity of the TIM itself and low interfacial thermal resistance between materials and the TIM. In order to reduce the interfacial thermal resistances, there is a need to increase the contact areas at the interface (to approximate to surface contact). Conventionally, for that purpose, a mixture of a polymer material having flexibility and fluidity for achieving surface contact and a highly thermally conductive inorganic filler for providing the TIM itself with a high thermal conductivity has been used (hereafter abbreviated as composite TIM).

Examples of the highly thermally conductive filler include molten silica (1 to 2 W/mK), aluminum oxide (20 to 35 W/mK), hexagonal boron nitride (30 to 60 W/mK), magnesium oxide (45 to 60 W/mK), and aluminum nitride (150 to 250 W/mK), and graphite is an example of the filler that is often used. On the other hand, a flexible polymer is often used as a fluid substance constituting a matrix. By using the flexible polymer, coupling at the interface forms a surface contact, and an air layer is removed from between the materials, so that the thermal resistance between the materials can be reduced. However, in such a composite TIM, there is a problem in that, when an amount of addition of the highly thermally conductive inorganic filler is increased, the flexibility is lost and, as a result, the thermal resistance at the interface increases. For this reason, in the composite TIM, the thermal conductivity of the TIM itself is 1 to 2 W/mK in the ordinary products or about 5 W/mK in highly thermally conductive products. Also, a typical thickness of the composite TIM is about 0.5 to 5 mm. This is because the TIM needs to enter by pressurization in accordance with the surface unevenness of the materials to be thermally coupled. Here, in the present specification, "pressurization" is also referred to as "application of a load".

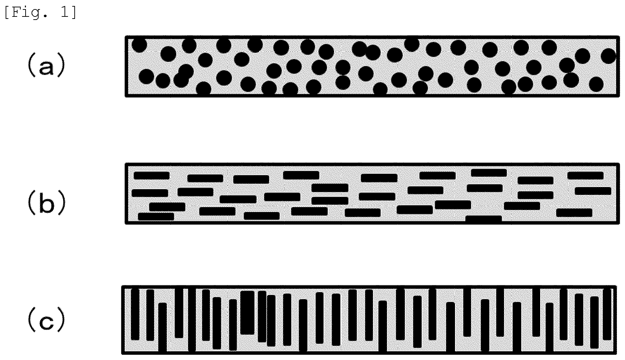

The thermal resistance of a practical property of the TIM is a sum of the thermal resistance of the TIM itself and the thermal resistance at the interface, and is typically about 0.4 to 4.0 K·cm²/W. Here, this thermal resistance changes in accordance with the magnitude of pressurization onto the coupling surface. Therefore, in order to display the thermal resistance thereof, the magnitude of the pressure must be described as well. A representative composite TIM is shown in Fig. 1. Fig. 1(a) shows a case in which the filler added to the flexible polymer is particle-like; Fig. 1(b) shows a case in which the added filler is scale-like; and Fig. 1(c) shows a case in which the scale-like filler is oriented in a vertical direction relative to the film surface for the purpose of improving the thermal resistance properties. Examples of such a composite TIM have been actually realized when a graphite filler is used.

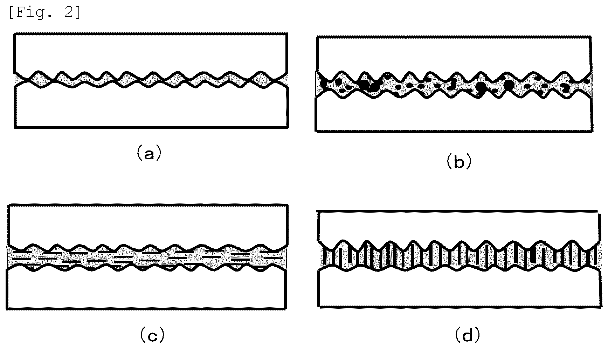

Fig. 2 shows a coupling state when various kinds of composite TIMs shown in Fig. 1 are actually interposed between materials. Fig. 2(a) shows a case in which the thermal coupling is implemented only with a flexible substance (not containing a thermally conductive filler). In such a case, air is removed because the flexible substance enters the surface unevenness of the materials, so that the thermal resistance can be lowered. In particular, when the surface unevenness of the materials is small and is in a state close to a mirror surface, the thickness of the flexible layer (hereafter also referred to as flexible substance layer) can be reduced by pressurization, so that the thermal resistance can be lowered simply with use of the flexible substance alone. However, in the thermal coupling with a flexible substance alone, it is known in the art that the flexible substance may be decomposed or diffused by partial concentration of heat (which phenomenon is referred to as bleeding), thereby raising a problem in that it is difficult to use the flexible substance alone for a TIM. Fig. 2(b) shows a case in which thermal coupling is implemented by using a composite TIM containing a particle-like filler, and Fig. 2(c) shows a case in which thermal coupling is implemented by using a composite TIM containing a scale-like filler. Also, Fig. 2(d) shows a case in which thermal coupling is implemented by using a composite TIM containing a longitudinally oriented scale-like filler. These fillers are involved in improving the thermal conductivity, and these fillers also play a role of preventing concentration of heat and evading the bleeding that may occur in Fig. 2(a).

The graphite is a material used as the highly thermal conductive filler and the present inventors have developed a TIM made of a thinner graphite film (Patent Document 1). Specifically, in Patent Document 1, the present inventors have developed the TIM made of the graphite film in which the graphite film has a thickness of 10 nm to 15 µm, a thermal conductivity in the film plane direction of 500 W/mK or more, and anisotropy of thermal conductivities of 100 or more in both the film plane direction and the thickness direction of the graphite film. Patent Document 1 also discloses that the TIM made of the graphite film exhibits excellent thermal resistance properties of from 0.98 K·cm²/W (thickness of 13 µm) to 0.33 K·cm²/W (thickness of 105 nm) under a pressure, for example, of 1.0 kgf/cm².

### PRIOR ART

### PATENT DOCUMENT

Patent Document 1: JP-A-2014-133669

### SUMMARY OF THE INVENTION

### PROBLEM TO BE SOLVED BY THE INVENTION

Thus, the property of the TIM made of the graphite film is particularly excellent when the TIM is interposed between mirror-surface materials. However, when the TIM is interposed between actual materials having unevenness, the thermal resistance thereof cannot be sufficiently lowered. Thus, an object of the present invention is to provide a thermal interface material applicable for practical materials having unevenness, a method for thermally coupling with the thermal interface material, and a method for preparing the thermal interface material.

### MEANS FOR SOLVING THE PROBLEMS

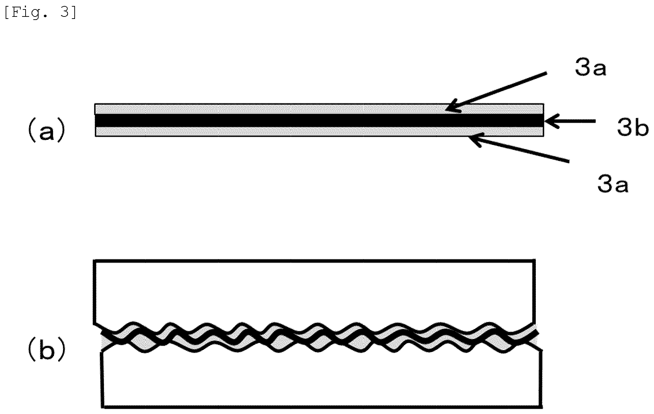

In order to improve inventions of the prior-application (Patent Document 1), the present inventors have developed a TIM having a different structure from the conventional composite TIM as shown in Fig. 3 (a), to complete the present invention. The reference numerals 3a and 3b denote a fluid substance (for example, flexible substance), and a graphite film, respectively. The TIM of the present invention is a thermal interface material for transferring heat by interposing between two materials, in which the thermal interface material comprises a graphite film having characteristics (physical properties) as set forth below and a fluid substance (a substance having a fluidity) for coating at least a surface of the graphite film. Fig. 3 (b) shows a coupling state in which the TIM of the present invention is interposed between materials having the unevenness. The graphite film of the present invention (hereinafter, referred to as graphite membrane in some cases) has a thinner thickness, and the shape of the graphite film is curved according to unevennesses on the surfaces of the materials, so that the graphite film can contact with the surface of the materials. In addition, uneven parts having no contact states form thermal contact points in which the convex parts on the surface of the materials enter the graphite film. On the other hand, the fluid substance enters recess parts of the materials, the space of the recess parts is filled with the fluid substance, so that the air layer of the recess parts is removed. By satisfying such a thermal coupling, the TIM of the present invention can realize the extremely excellent thermal resistance of 0.4 °C·cm²/W or less. Such an excellent thermal resistance has been not achieved in the conventional composite TIM.

As will be described later, the graphite film used in the present invention including the preferable embodiments has an extremely high thermal conductive property (500 W/mK or more) in the film plane direction, and the heat that has flowed in from the thermal coupling point between the material and the TIM is immediately diffused in the graphite film plane direction, so that the heat can be let to flow out from numerous thermal coupling points between the opposite material and the graphite film. In other words, the TIM made of the graphite film of the present invention including the preferable embodiments can achieve excellent thermal resistance properties owing to (1) the small bulk thermal resistance deriving from the feature that the graphite film is thin, (2) the bleeding prevention effect produced by the interposed graphite film, and (3) the multiple-point coupling effect that the coupling state is equivalent to a state in which one coupling point is thermally coupled to numerous points due to the high thermal conductivity of the interposed graphite film in the plane direction. Such a mechanism of thermal conduction is totally different from the mechanism of a conventional TIM shown in the Figs. 2(a), 2(b), 2(c), and 2(d).

Further, a new fact that was not conventionally known in the art at all has been made clear, that is, it has been found out that the pressure dependency of the thermal resistance can be made extremely small by forming the TIM structure of the present invention. The TIM of the present invention has features that the thermal resistance when measured under an applied pressure of 0.2 MPa is 0.4 °C·cm²/W or less (preferably 0.3 °C·cm²/W or less), and the pressure dependency of the thermal resistance is extremely small. For example, the pressure dependency of the thermal resistance when pressure is applied with magnitudes of 0.1 MPa and 0.5 MPa (the ratio (R_{0.1/}R_{0.5}) of the thermal resistance (R_{0.1}) when a load of 0.1 MPa is applied to the thermal resistance (R_{0.5}) when a load of 0.5 MPa is applied) can be made to be 1.8 or less. The facts that the pressure dependency of the thermal resistance is extremely small and that a low thermal resistance property is exhibited with a small applied pressure mean that mechanical strong fastening is not needed. Further, the thermal resistance thereof is affected little even when mechanical fastening is loosened, so that the TIM exhibits a practically extremely useful property.

In the TIM of the present invention including the preferable embodiments, excellent thermal resistance of 0.4 °C·cm²/W or less beyond the common properties of the conventional composite TIM is achieved by the following two points. Specifically, (1) the graphite film satisfies conditions such as thickness, thermal conductivity and the like, and (2) thickness of the layer composed of the fluid substance or amount of the fluid substance on the surface of the materials is controlled in order to thermally couple between materials having the unevenness, which has been difficult in the invention of the Patent Document 1.

The thermal interface material of the present invention contains a thermal interface material for transferring heat by interposing between two materials, wherein the thermal interface material contains a graphite film and a fluid substance, the graphite film has a thickness of 100 nm to 15 µm, and a weight ratio of the fluid substance to the graphite film is 0.08 to 25. In other words, it is necessary that the weight of the fluid substance of the present invention (preferably the weight of the fluid substance formed on the surface of the graphite film) is more than the weight of the graphite film. The used amount of the fluid substance seems to be sufficient in a small amount because the fluid substance is used to reduce the interfacial resistance. However, in the case where the graphite film of the present invention has an extremely thinner thickness, the fluid substance is needed in an amount of equal to or more than the amount of the graphite film, and the excellent thermal resistant property can be realized by using the fluid substance in a larger amount of than that of the graphite film. In addition, the graphite film preferably has a thermal conductivity of 500 W/mK to 2000 W/mK in a film plane direction and a density of 1.20 g/cm³ to 2.26 g/cm³.

The fluid substance of the present invention is not limited to one capable of flowing and moving, and may have a property of entering the unevenness on the surface of the materials. In other words, the term "fluid substance" refers to all of a fluid substance that flows at ordinary temperature or by heating and a substance having a property of being deformed by heating, pressurization at an ordinary temperature, or by both of pressurization and heating. A flexible substance is one example of the fluid substance. The fluid substances in the present invention can be classified into a substance that is in a solid at an ordinary temperature and a substance that is in a liquid at an ordinary temperature. Here, the ordinary temperature refers to 20 °C. Among the aforementioned fluid substances, the fluid substance that is solid at an ordinary temperature refers to one that is deformed to exhibit fluidity by heating, pressurization at an ordinary temperature, or by both of pressurization and heating. The fluid substances include substances such as gel, grease, and wax besides the flexible polymer materials. Also, when the fluid substance is solid at an ordinary temperature, the thickness of the fluid substance on load at prescribed temperature and pressure becomes 1/2 or less of the thickness with no load at an ordinary temperature. With respect to a substance that is solid at an ordinary temperature, a preferable pressure for the substance to exhibit fluidity according to such a definition is 0.5 MPa or less, and a preferable temperature for the substance to exhibit flexibility is 100 °C or lower under the aforementioned pressure. The TIM of the present invention flows and moves by the pressure at the time of forming the thermal coupling, or by pressure and heating, and enters the unevenness of the material to be thermally coupled. As a result, the air layer between the materials is removed, and an excellent thermal resistance property is exhibited. An optimal thickness of the layer composed of the fluid substance (flexible substance layer) changes depending on the size of the unevenness of the interposing materials. In other words, in the case of a material having a large unevenness, the thickness of the needed fluid substance layer is large. In the case of a material having a small unevenness, the thickness of the needed fluid substance layer is small.

Further, a liquid substance having the fluidity at an ordinary temperature such as an oil can be used as the fluid substance. In the present invention, the fluid substance which is a liquid at an ordinary temperature refers to a liquid substance having a boiling point of 150 °C or more. The conventional composite TIM cannot use such a liquid substance as a matrix because it is necessary to form a film with a polymer in the conventional composite TIM. However, such a liquid substance can be used in the TIM of the present invention because the graphite film is present as a layer of a core material.

In order to realize the thermal resistant property to be targeted by using the TIM of the present invention, the materials has unevenness of Ra and Rz as set forth below. The mathematical surface roughness (arithmetic average roughness) Ra of the materials is preferably 3 µm or less, more preferably 2 µm or less, and even preferably 1 µm or less, and the ten-points average roughness Rz of the materials is preferably 10 µm or less, more preferably 5 µm or less, and even preferably 3 µm or less. There is a tendency to decrease the thermal resistance as the surface of the material becomes mirror surface, and the TIM of the present invention can realize a decreased thermal resistance even when applied to materials having unevenness. Therefore, Ra may be 0.2 µm or more, 1 µm or more, or 1.5 µm or more. Also, Rz may be 1.0 µm or more, 2.0 µm or more, and 4.0 µm or more. According to the TIM of the present invention, the decreased thermal resistance can be realized even when the above Ra and Rz satisfy the above range. In the case where the graphite film of the present invention is individually used as the TIM and the case where the layer composed of the fluid substance is formed in an amount out of the range of the present invention, the present invention can hardly apply to materials having the unevennesses of which Ra is 0.2 µm or more and Rz is 1.0 µm or more. Therefore, it is difficult to realize excellent thermal resistance of 0.4 °C·cm²/W or less exceeding properties of the conventional composite TIM. Also, in the case where the layer composed of the fluid (flexible) substance is formed in an amount which is 20 times or more as large as that of the graphite film, it is difficult to realize excellent thermal resistance of 0.4 °C·cm²/W or less exceeding properties of the conventional composite TIM because the fluid (flexible) substance having a low thermal conductivity has great influences on thermal resistances.

The method for preparing a TIM made of the graphite film of the present invention is not limited particularly, and it is preferable that the graphite film is prepared by carbonizing a polymer film to obtain a carbonized film, and graphitizing the carbonized film. It is preferable that in at least one of the carbonizing step and the graphitizing step, a spacer is laminated on the polymer film, the carbonized film, or the graphite film, and a laminate of the spacer and the polymer film, the carbonized film, or the graphite film is carbonized and/or graphitized while pressing. The spacer is not limited particularly as long as the spacer has a desirable unevenness, durability, and heat resistance, and, as a one example, it is preferable that the spacer contains a felt composed of a carbon such as a carbon fiber or a graphite fiber.

The kinds of materials used in the polymer film are not limited particularly, and the polymer film preferably contains a condensed aromatic polymer. In addition, it is preferable that the polymer film containing the condensed aromatic polymer has a thickness of 200 nm to 40 µm, and the condensed aromatic polymer contains an aromatic polyimide. Further, it is preferable that the film containing the aromatic polyimide is carbonized and graphitized at a temperature of 2400 °C or more to prepare the graphite film.

Specifically, the present invention to solve the above problem is as follows:
(1) A thermal interface material for transferring heat by interposing between two materials, wherein the thermal interface material contains a graphite film and a fluid substance, the graphite film has a thickness of 100 nm to 15 µm, and a weight ratio of the fluid substance to the graphite film is 0.08 to 25.
(2) The thermal interface material according to (1), wherein the graphite film has a density of 1.20 g/cm³ to 2.26 g/cm³, and a thermal conductivity of 500 W/mK to 2000 W/mK in a film plane direction.
(3) The thermal interface material according to (1) or (2), wherein the fluid substance is a solid at 20 °C, the fluid substance has a deformation property on a load of 0.5 MPa at 20 °C, and a thickness of the fluid substance after the deformation is 1/2 or less a thickness of the fluid substance before the deformation.
(4) The thermal interface material according to (1) or (2), wherein the fluid substance is a liquid at 20 °C, and the fluid substance has a boiling point of 150 °C or more.
(5) The thermal interface material according to any one of (1) to (3), wherein the fluid substance contains at least one selected from an acrylic polymer, an epoxy resin, and a silicone polymer.
(6) A method for thermally coupling materials with the thermal interface material according to any one of (1) to (5), wherein a thermal resistance of the thermal interface material is 0.4 °C·cm²/W or less on a load of 0.2 MPa.
(7) A method for thermally coupling materials with the thermal interface material according to any one of (1) to (5), wherein a ratio of a thermal resistance R_{0.1} on a load of 0.1 MPa to a thermal resistance R_{0.5} on a load of 0.5 MPa of the thermal interface material is 1.0 to 1.8.
(8) A method for thermally coupling materials with a thermal interface material for transferring heat from a first material to a second material, wherein the fluid substance contacts with at least one of the first material and the second material, the graphite film contacts with the fluid substance, the graphite film has a thickness of 100 nm to 15 µm, and a weight ratio of the fluid substance to the graphite film is 0.08 to 25.
(9) A method for preparing the thermal interface material according to any one of (1) to (5), containing carbonizing a polymer film to form a carbonized film, and graphitizing the carbonized film to form a graphite film.
(10) The method according to (9), wherein the polymer film comprises a condensed aromatic polymer.
(11) The method according to (10), containing carbonizing and graphitizing the polymer film containing the condensed aromatic polymer at a temperature of 2400 °C or more, wherein the polymer film containing the condensed aromatic polymer has a thickness of 200 nm to 40 µm, and the condensed aromatic polymer contains an aromatic polyimide.

### EFFECT OF INVENTION

According to the present invention, the thermal interface material having excellent thermal coupling properties compared with that of the conventional composite TIM, the possible application for practical materials having unevenness compared with invention of Patent Document 1, and the extremely decreased pressure dependence of the thermal resistance can be provided.

### BRIEF DESCRIPTION OF THE DRAWINGS

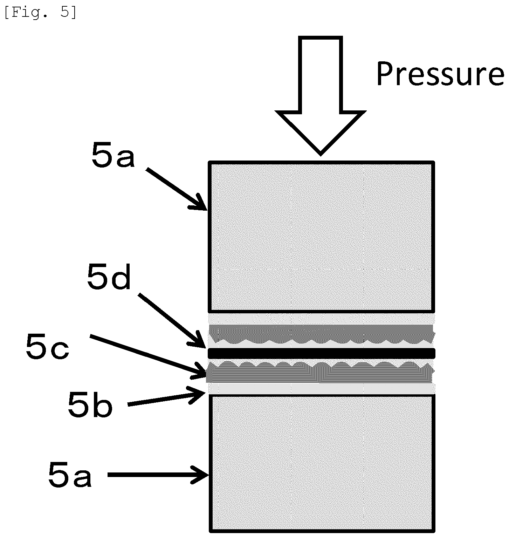

[Fig. 1] Fig. 1 shows examples of various types of composite TIMs, where Fig. 1 (a) shows a TIM made of a particle-like thermally conductive filler and a fluid substance; Fig. 1 (b) shows a TIM made of a scale-like filler and a fluid substance; and Fig. 1(c) shows a TIM made of a vertically oriented scale-like filler and a fluid substance.
[Fig. 2] Fig. 2 shows coupling states between materials using various types of composite TIMs, where Fig. 2(a) shows a case in which thermal coupling is implemented only with a fluid substance; Fig. 2 (b) shows a case in which thermal coupling is implemented by using a composite TIM containing a particle-like filler; Fig. 2(c) shows a case in which thermal coupling is implemented by using a composite TIM containing a scale-like filler; and Fig. 2 (d) shows a case in which thermal coupling is implemented by using a composite TIM containing a vertically oriented scale-like filler.
[Fig. 3] Fig. 3 (a) shows one example of a structure of a TIM of the present invention, and Fig. 3(b) is an image view when the TIM of the present invention is interposed between materials. In the present invention, the graphite film is partially in contact in correspondence with the unevenness of the materials, and the concave parts of the materials that could not be in contact are filled with a fluid substance.

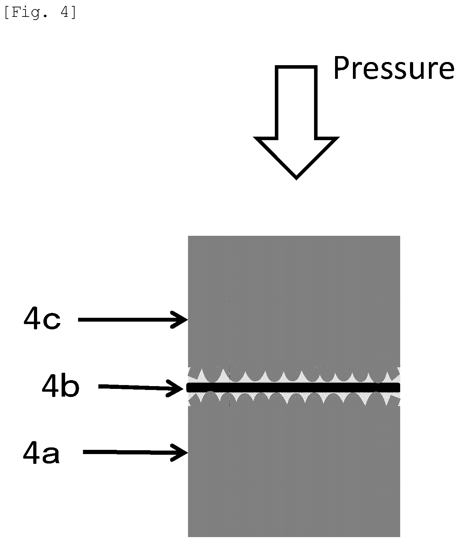

[Fig. 4] Fig. 4 is a view of a principle-1 of a method for measuring the thermal resistance between materials having surface roughness.
[Fig .5] Fig. 5 is a view of a principle-2 of a method for measuring the thermal resistance property between materials having surface roughness.

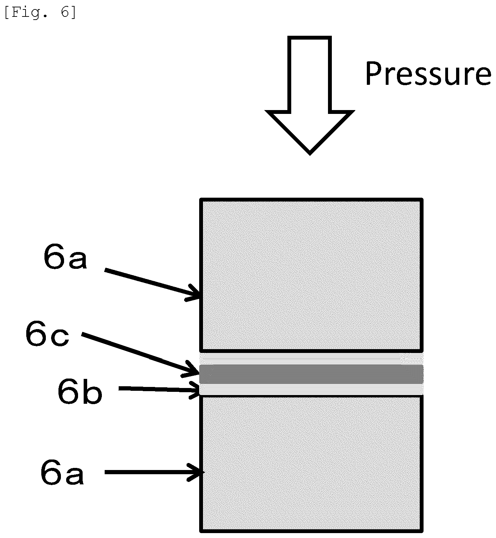

[Fig. 6] Fig. 6 is a view of a principle-3 of a method for measuring the thermal resistance property between materials having surface roughness. The thermal resistance measured by this method is subtracted from the thermal resistance measured by the method of Fig. 5.

### MODE FOR CARRYING OUT THE INVENTION

Hereafter, embodiments of the present invention will be described in detail. Here, all of the academic documents and patent documents described in the present specification are incorporated in the present specification as a reference. Also, in the present specification, unless specifically mentioned otherwise, the term "A to B" representing a numerical range means "A or more (inclusive of A and more than A) and B or less (inclusive of B and less than B)".

### (A) Graphite film

The graphite film of the present invention has a thickness of 100 nm to 15 µm. The graphite film has a thickness of preferably 200 nm or more, and most preferably 300 nm or more. The graphite film has a thickness of preferably 15 µm or less, 12 µm or less, and most preferably 10 µm or less. The graphite film of the present invention has a density of preferably 1.20 g/cm³ to 2.26 g/cm³, more preferably 1.40 g/cm³ to 2.26 g/cm³, and most preferably 1.60 g/cm³ to 2.26 g/cm³. The density of 2.26 g/cm³ is an ideal density in the graphite film containing no air layer. The inclusion of the air layer in the graphite film can be confirmed by measuring a density of the graphite film. It is desirable that there is little air layer within the graphite film because the air layer has an extremely decreased thermal conductivity. Like this, the density can be considered as a measure of the presence of the air layer.

Also, the graphite film of the present invention has the thermal conductivity in the film plane direction of preferably 500 W/mK or more, more preferably 600 W/mK or more, even preferably 800 W/mK or more, and most preferably 1000 W/mK or more. The larger the thermal conductivity in a film plane direction, the more the heat is transferred. The maximum thermal conductivity of the graphite film is 2000 W/mK in a-b plane direction. Therefore, the graphite film preferably has the thermal conductivity of 500 W/mK or more and 2000 W/mK or less in the present invention.

### (B) Method for preparing polymer film

A method for preparing the graphite film is not limited particularly and the graphite film can be prepared by baking of the polymer film. The polymer is preferably a condensed aromatic polymer, and the polymer is preferably at least one selected from polyamide, polyimide, polyquinoxaline, polyoxadiazole, polybenzimidazole, polybenzoxazole, polybenzthiazole, polyquinazolinedione, polybenzoxazinone, polyquinazolone, benzimidazobenzophenanthroline ladder polymer, and derivatives thereof.

The polymer film is preferably a condensed aromatic polyimide film in the view of the conversion of the polymer film to the high quality graphite. In addition, the condensed aromatic polyimide film is preferably a film having controlled molecular structures and higher structures and excellent orientation in the view of the simple conversion to the high quality graphite. The condensed aromatic polyimide film can be produced by various publicly known techniques. For example, the polyimide film of the present invention is produced by casting the above-mentioned organic solvent solution containing a polyamic acid as a polyimide precursor on a support such as an endless belt or a stainless steel drum, drying and imidizing the solution.

Examples of a method for producing a polyimide include, without particularly limiting, a thermal cure method in which a polyamic acid of a precursor is imidized by heating, and a chemically curing method in which both or one of a dehydrating agent typified by acid anhydrides such as acetic anhydride and tertiary amines such as picoline, quinoline, isoquinoline and pyridine, is used as an imidization accelerator for polyamic acid to perform imidization. Specifically, a method for preparing a polyimide film using the chemically curing method is as follows. The dehydrating agent containing a larger amount than an amount of stoichiometry and the imidization accelerator containing the same amount as a catalyst are added to a solution containing a polyamic acid and an organic solvent to prepare a mixture, the mixture is casted or coated on a substrate, an organic film such as PET, or a supporting body such as drum or endless belt to prepare a film-like layer, drying the organic solvent by heating to prepare a film having mechanical strength. Then, the film is further heated, dried, imidized to prepare a polyimide film composed of the polyimide polymer.

The temperature of heating is preferably the range of from 150 °C to 550 °C. The increasing rate of the temperature for heating the polymer is not limited particularly, and it is preferable that the polymer is continuously, intermittently or gradually heated to control the maximum temperature within the above range. Further, in the course of the preparation of the polyimide, it is preferable that the film is fixed or expanded to prevent the shrinkage. The fixation or the expansion of the film can increase the orientation of the polymer.

The thickness of the graphite film finally obtained is changed according to a thickness of a polymer film as a raw material. In the aromatic polyimide, a thickness of the graphite film finally obtained is commonly often about 60 % to 40 % of a thickness of a starting polymer film having a thickness of 1 µm or more, or about 50 % to 40 % of a thickness of a starting polymer film having a thickness of 1 µm or less. Accordingly, in order to obtain a graphite film having a thickness of 100 nm to 15 µm, a starting polymer film preferably has a thickness of from 200 nm to 40 µm (preferably 200 nm to 37.5 µm). The aromatic polyimide film has, for example, an average linear thermal expansion coefficient of 0.5 × 10⁻⁵ to 5.0 × 10⁻⁵ cm/cm/°C at 100 °C to 200 °C and a birefringence of 0.1 to 0.2.

### (C) Method for preparing graphite film

A method for preparing a graphite film used in the TIM (thermal interface material) of the present invention is not limited particularly as long as the graphite having necessary properties is obtained. The graphite film is preferably prepared by carbonization and graphitization of a polymer film. The carbonization and the graphitization may be carried out at one furnace or separate furnaces. The carbonization and the graphitization of the polymer film is explained as follows. The carbonization is not limited particularly, and the polymer film of a starting material is preliminarily heated to carbonize the polymer film in an inert gas or in a vacuum. The inert gas preferably includes nitrogen gas, argon gas, a mixed gas of argon and nitrogen. The preliminary heating is carried out at a temperature of about 1000 °C. The increasing rate of the temperature to the preliminary heating temperature is preferably 5 °C/minute or more, more preferably 8 °C/minute or more. The increasing rate of the temperature to the preliminary heating temperature is preferably 15 °C/minute or less and more preferably 12 °C/minute or less. The holding time of the preliminary heating temperature is preferably 30 minutes or more, even preferably 1 hour or more, and preferably 2 hours or less. It is desirable that the tension of the plane direction is applied at a degree of no break of the film such that the orientation of the starting polymer film is not decreased at the stage of the preliminary heating.

The graphitization of the polymer is not limited particularly, and the film carbonized with the above method is set in a furnace at a high temperature to graphitize the film. The graphitization is carried out in an inert gas, and the inert gas is appropriately argon and both argon and helium in a small amount may be used. The maximum treatment temperature (HTT) for the graphitization is preferably 2400 °C or more, more preferably 2600 °C or more, and most preferably 2800 °C or more from the view of the conversion to high quality graphite film at a higher temperature. The upper limit of the maximum treatment temperature (HTT) for the graphitization may be, without limiting particularly, 3600 °C or less or 3500 °C or less. The increasing rate for HTT is preferably 10 °C/minute or more, and more preferably 15 °C/minute or more, and preferably 30 °C/minute or less, and more preferably 25 °C/minute or less. The holding time for HTT is preferably 5 minutes or more, more preferably 10 minutes or more, and the holding time for the graphitization is preferably 20 minutes or less.

When the aromatic polyimide of the polymer film is carbonized, the carbonized film is shrunk to reduce the original area of the original polymer film by about 75 % to 85 % at the carbonization in many cases. In addition, when the shrinkage and the expansion of the film during carbonization and graphitization is left to nature, the area of the finally obtained graphite film is enlarged compared with the carbonized film, the dimension of the graphite film is about 85 % to 95 % of the dimension of original polymer film. Thus, due to natural shrinkage and expansion, the graphite film prepared by the conventional methods has wrinkles generated over the whole film plane in some cases. When the graphite film having the wrinkles is only used as the TIM, the graphite film affected properties of TIM. However, when the layer composed of the fluid substance is formed on the surface of the graphite film, there is no great problem.

However, the stable properties of the TIM preferably result from the preparation of the graphite film having controlled wrinkles. It is preferable that the graphite film has Ra of 0.1 µm to 10 µm as to wrinkles on surfaces. A method for controlling a size of the wrinkle of the graphite film is not limited particularly, and it is preferable that in at least one of the carbonization step and the graphitization step, a spacer having an unevenness of a suitable size is laminated onto at least one plane of the sample such as a polymer film, a carbonized film, or a graphite film, interposing these between flat and smooth pressing plates or jigs, and treating at a carbonization temperature and a graphitization temperature while pressurizing with a suitable pressure from both sides.

In the present invention, a suitable wrinkle is formed by controlling the shrinkage and expansion through a pressing treatment using a spacer. Specifically, a suitable wrinkle can be formed when a spacer having an unevenness with a suitable size is laminated onto both surfaces of a polymer film, a carbonized film, or a graphite film, interposing these between flat and smooth pressing plates, and treating at a carbonization temperature and a graphitization temperature while pressing with a suitable pressure from both sides. The spacer preferably has Ra of 3 µm or more and 7 µm or less. The pressure to be applied to the sample is preferably 50 gf/cm² or more and 150 gf/cm² or less. Here, the carbonization is carried out on a polymer film, and the graphitization is carried out on a carbonized film. Also, a re-graphitization may be carried out in accordance with the needs. The re-graphitization is carried out on a graphite film. In the case where the graphitization is carried out after a polymer film is carbonized, the aforementioned pressing treatment may be carried out in one of the carbonization step and the graphitization step or in both of the steps. The materials of the spacer are not particularly limited as long as the materials have durability against a high-temperature treatment; however, typically, the spacer is preferably a carbon material or a graphite material. For example, a substrate made of CIP (Cold Isotropic Press: cold hydrostatic press) material that is isotropic graphite or glassy carbon can be used.

### (D) Formation of layer composed of fluid substance

A layer having fluidity, a layer composed of the fluid substance, or a fluid layer is preferably formed on the graphite film (preferably on the surface of the graphite film) prepared by the aforementioned method. At this time, the layer composed of the fluid substance may be formed on at least a part of the surface of the graphite film. The layer composed of the fluid substance is preferably formed on one surface of the graphite film, and more preferably formed on both surfaces of the graphite film. An acrylic polymer, an epoxy resin, a silicone polymer, and the like that are used in a conventional composite TIM are materials for forming a particularly preferable fluid layer. When the material for forming the layer composed of the fluid substance is in a solid form at an ordinary temperature, the materials exhibit fluidity by pressurization at an ordinary temperature or by both of pressurization and heating, so as to enter the unevenness of the materials to be thermally coupled. As a result, the air layer between the materials is removed to exhibit an excellent thermal resistance property. As already described, a preferable pressure for exhibiting the fluidity is 0.5 MPa or less, and the temperature is preferably 100 °C or lower. The pressure is more preferably 0.4 MPa or less, even preferably 0.3 MPa or less, and most preferably 0.2 MPa or less. The temperature is more preferably 80 °C or lower, even preferably 60 °C or lower, and most preferably 40 °C or lower.

A method for forming the layer composed of the fluid substance on the surface of the graphite film is not particularly limited; however, when the layer composed of the fluid substance contains a flexible polymer, the polymer layer made into a film may be press-bonded by the lamination method, or may be formed by interposing and press-bonding the graphite film between two sheets of polymer layers formed to have a predetermined thickness. Also, a polymer dissolved in a solvent may be applied. Also, such a layer composed of the fluid substance may be formed in advance on a material to be thermally coupled, and thereafter pressurized in performing thermal coupling to eventually form a TIM structure of the present invention. When the TIM formed by such a method is eventually formed of the graphite film and the fluid substance within the range of the present invention, such a TIM is comprised within the range of the present invention. In the present invention, it is preferable that the fluid substance is solid at 20 °C, the fluid substance has a deformation property on a load of 0.5 MPa at 20 °C, and a thickness of the fluid substance after the deformation is 1/2 or less the thickness of the fluid substance before the deformation, because of facilitating the handling.

When the fluid substance is solid at 20 °C, the thickness of the fluid substance (total thickness) is preferably 0.1 µm or more, more preferably 0.2 µm or more, and even preferably 0.5 µm or more, and is preferably 20 µm or less, more preferably 10 µm or less, and even preferably 5 µm or less, in view of the fact that the fluid substance is not simply used for the purpose of reducing the interfacial resistance by surface modification of graphite but is used for the purpose of filling the unevenness of the materials.

The layer formed on the graphite film surface may be a fluid substance in a liquid form. When the fluid substance is a liquid, the fluid substance is preferably a mineral oil, a vegetable oil, a synthesized oil, a purified edible oil, an animal oil, or a mixture of these. For example, in the case of an oil, a mineral oil, a synthesized hydrocarbon oil, an ester oil, a polyglycol oil, a silicone oil, a fluorine oil, a canola oil, or a mixture of these may be suitably used. Also, the fluid substance may be a modified oil. For example, in the case of a silicone oil, an epoxy modified silicone oil, a polyether-modified silicone oil, an amino-modified silicone oil, or an epoxy modified silicone oil can be used. The fluid substance preferably has a low vapor pressure so as not to lose the thermostability and high durability property of the features of the TIM of the present invention. A preferable boiling point of the fluid substance of the present invention is 150 °C or higher, and the boiling point is more preferably 200 °C or higher, even preferably 250 °C or higher, and most preferably 300 °C or higher. An upper limit of the boiling point is not particularly limited; however, the boiling point is preferably 500 °C or lower.

In order to apply the liquid substance as the fluid substance onto the graphite film surface, the graphite film may be immersed into the liquid substance and thereafter pulled up. In this case, the application amount is determined by comparing the weight of the graphite film before the immersion and the weight after the immersion. In order to control the application amount, an extraneous oil may be wiped off after excessive application.

The weight ratio (A/B) of the fluid substance (A) to the graphite film (B) of the present invention is within a range of 0.08 to 25, preferably 1.0 to 20. The ratio (A/B) is preferably 0.2 or more, more preferably 0.5 or more, and even preferably 1.0 or more, and is preferably 20 or less, more preferably 15 or less, and even preferably 10 or less. When the fluid substance is formed on both surfaces of the graphite film, the amount of the fluid substance means a sum of the amounts on both surfaces. Here, for example, when the weight ratio of (fluid substance/graphite film) is 2, the same amount of the fluid substance is applied onto both surfaces of the graphite film, the same weight of the fluid layer as that of the graphite film is formed on one graphite film surface. However, the amounts of the fluid substance formed on the two surfaces of the graphite film may be the same or different, and is preferably the same. In the TIM of the present invention, the reason why the fluid substance (A) is extremely large in amount is that such a fluid substance is not simply used for the purpose of reducing the interfacial resistance by surface modification of graphite but is necessary for filling the unevenness of the materials as well.

### (E) Method for thermally coupling with thermal interface material

A method for thermally coupling with a thermal interface material (TIM) of the present invention includes a step of placing the TIM between the materials to be thermally coupled. In other words, the method for thermally coupling with the thermal interface material of the present invention transfers heat from one material (first material) to the other material (second material), by bringing the TIM into contact with the two materials, and placing (interposing) the TIM according to the present invention between two materials. The materials preferably have Ra of 3 µm or less and Rz of 10 µm or less. By interposing the TIM of the present invention between materials, heat from the heat generation source or the material thermally coupled to the heat generation source (first material) can be transferred to the second material having a lower temperature, to carry out thermal coupling. The TIM is placed by being interposed between the material near to the heat source and the material far from the heat source, and the TIM is in direct contact with each material. As a coupling method, fixation may be made with a simple mechanical pressure. Mechanical swaging with a screw, a thread, a spring, or the like is effective and preferable. However, there is not necessarily a need for strong swaging in considerations of the fact that low thermal resistance can be achieved under a low pressure as a feature of the present invention, and the fact that the pressure dependency of the thermal resistance is small. Even when the swaging pressure changes, the influence thereof is small, so that a practically extremely effective thermal coupling at interface can be realized. When a load is applied with a mechanical pressure or the like, the value of the pressure may be 0.1 MPa or more, preferably 0.2 MPa or more. An upper limit of the pressure is not particularly limited; however, the pressure is preferably 5 MPa or less, more preferably 3 MPa or less, and even preferably 1 MPa or less, because the applied effect is saturated when the pressure is too large, and also the graphite film may break by excessive pressure. By the method of the present invention, the thermal resistance when a load of 0.2 MPa is applied can be made to be 0.4 °C·cm²/W or less. Also, the ratio (R_{0.1}/R_{0.5}) of the thermal resistance (R_{0.1}) when a load of 0.1 MPa is applied to the thermal resistance (R_{0.5}) when a load of 0.5 MPa is applied can be made to be 1.0 to 1.8. The ratio R_{0.1}/R_{0.5} is preferably 1.7 or less, more preferably 1.5 or less, and even preferably 1.3 or less.

Also, the optimal amount of the fluid substance is determined in accordance with the surface unevenness of the materials to be thermally coupled. In the case of the TIM of the present invention, it is not essential to weigh the amount of the fluid substance in advance for coupling. This is because, by the pressure at the time of performing thermal coupling, extraneous amount of the fluid substance (that is, the fluid substance that remains and becomes extraneous after filling the unevenness of the materials) runs over from the coupling part, so that the remaining portion can be wiped off and removed. Further, good thermal coupling can be made even if the fluid substance is formed in advance on the surface of the materials. Accordingly, in the present invention, it is sufficient that the weight ratio of the fluid substance to the graphite film in the thermal coupling material is eventually within the range of the present invention, so that the thermal coupling formed in such a manner is also comprised within the scope of the present invention. In other words, the present invention contains a method for thermally coupling with the thermal interface material by transferring heat from a first material to a second material, wherein a fluid substance contacts with at least one of the first material and the second material; a graphite film contacts with the fluid substance; the graphite film has a thickness of 100 nm to 15 µm; and a weight ratio (A/B) of the fluid substance (A) to the graphite film (B) is 0.08 to 25. The layer composed of the fluid substance preferably contacts with one surface of the graphite film, and more preferably contacts with both surfaces of the graphite film.

The TIM of the present invention may be laminated in a plurality of sheets in accordance with the needs. For example, a plurality of sheets of the graphite film having a thickness of 1 µm may be laminated to fabricate a TIM having an optimal thickness. When graphite film is laminated in such a manner, the coupling between graphite films is preferably formed with an extremely small amount of a fluid substance. For example, the weight of the fluid substance used for such lamination between graphite films may be 0.1 or less relative to the weight of the graphite film. In performing lamination of a plurality of sheets, the TIM of the present invention may be simply laminated and press-bonded, and it is preferable to carry out heat treatment in press-bonding. Also, instead of press-bonding, it is possible to perform roll-bonding by passing the TIM between rolls provided with a certain gap.

According to the present invention, the thermal interface material is suitably used in electronic devices and LED (Light Emitting Diode) illumination, which is required for effective transfer of heat from a heat generating source to a heat dissipating and cooling material such as a circuit substrate, a cooling fin, and a heat sink.

The present application claims the benefit of priority to Japanese Patent Application Number 2017-017696 filed on February 2, 2017. The entire contents of the specification of Japanese Patent Application Number 2017-017696 filed on February 2, 2017 are hereby incorporated by reference.

### EXAMPLES

Hereinafter, the present invention will be described in detail with reference to Examples, but the present invention is not limited thereto, and the variation and the modification of the present invention without departing the gist described above and below are all included the technical scope of the present invention.

### <Measurement method of physical property>

First, a method of measuring the physical properties in the following Examples is shown in the following.

### (1) Thickness of graphite film

The thickness at arbitrary five sites of a graphite film cut out to have a size of 50 × 50 mm² was measured with a contact-type thickness gauge, and an average value thereof was determined as the thickness of the graphite film.

### (2) Density of graphite film

The density of the graphite film was measured by using a dry-type automatic density meter AccuPyc II 1340 (manufactured by Shimadzu Corporation) . The density was measured sheet by sheet with respect to the five sheets of graphite film cut out to have a 50 × 50 mm² shape, and an average value thereof was determined as the density.

### (3) Thermal conductivity of graphite film

The thermal diffusion rate of graphite film was measured by using a thermal diffusion rate measurement apparatus employing the periodic heating method ("LaserPit" apparatus manufactured by ULVAC, Inc.) and using a frequency of 10 Hz at 25 °C in vacuum (about 10⁻² Pa). This was a method of attaching a thermocouple at a point spaced apart by a certain distance from the point of laser heating and measuring the temperature change thereof. However, by this method, when the thickness of the graphite film was 1 µm or less, it was impossible to perform correct measurement, because the measurement error was too large. Accordingly, as a second measurement method, measurement was carried out using the periodic heating radiation temperature-measuring method (Thermoanalyzer TA3 manufactured by BETHEL Co., Ltd.). This was an apparatus in which periodic heating was carried out with laser, and temperature measurement was carried out with a radiation thermometer, and the apparatus was completely in no contact with the graphite film during the measurement, so that even a sample in which the thickness of the graphite film was 1 µm or less can be measured. In this apparatus of BETHEL Co., Ltd., the frequency of periodic heating can be changed within a range up to 800 Hz at the maximum. In other words, the characteristic feature of this apparatus lies in that the temperature measurement is carried out with a radiation thermometer, and the measurement frequency can be variable. In principle, a constant thermal diffusion rate can be measured even when the frequency was changed, so that, in the measurement using the present apparatus, the measurement was carried out by changing the frequency. When a sample having a thickness of 1 µm or less was measured, the measurement value was often varied at the measurement of 10 Hz or 20 Hz; however, the measurement value was almost constant at the measurement of 70 Hz to 800 Hz. Accordingly, the thermal diffusion rate was determined by using a numerical value that indicated a constant value irrespective of the frequency (value at 70 Hz to 800 Hz). The thermal conductivity (W/mK) was calculated by multiplying the thermal diffusion rate (m²/s), the density (kg/m³), and the specific heat (798 kJ/(kg·K)).

### (4) Measurement of thermal resistance of TIM

The thermal resistance of the TIM made of the graphite film of the present invention was measured by using a precision thermal resistance measurement apparatus manufactured by Hitachi Technologies and Services, Ltd. The present measurement apparatus was an apparatus capable of measuring a precise thermal resistance, and an error thereof was ±0.002 °C·cm²/W. The sample dimension was 10 × 10 mm²; the load was 10 to 50 N (corresponding to 1.0 kgf/cm² to 5.0 kgf/cm²); and the measurement temperature was 60 °C. Specifically, first the applied watt number (W) was adjusted so that the interfacial temperature was 60 °C, and the measurement was made for 10 times after the temperature change became constant. An average value thereof was determined as the measured value of the thermal resistance.

The above was a standard method of measuring the thermal resistance, and the measurement rod surface of the above thermal resistance measurement apparatus was subjected to mirror surface finishing and was different from the material surface having practical unevenness. In order to measure the thermal resistance between practical materials having unevenness, the thermal resistance was measured by interposing between materials having unevenness in as shown in Fig. 4. The reference numerals 4a, 4b, and 4c denote the first material, the TIM (thermal interface material) made of the graphite film, and the second material, respectively. As shown below, the thermal resistance measurement between the materials having unevenness was conducted by using the above measurement apparatus.

Fig. 5 shows a method of measuring the thermal resistance using a material having a surface roughness. The reference numeral 5a denotes the measurement rod of the above precision thermal resistance measurement apparatus manufactured by Hitachi Technologies and Services, Ltd. The reference numeral 5c denotes a copper foil having a surface roughness, that is, an unevenness of a certain size on one surface. This copper foil was coupled by using the rod 5a and the silicone grease 5b. The reference numeral 5d denotes a TIM made of a graphite film (thermal interface material) of the present invention. First, the thermal resistance property was measured while changing the load using copper foils having different surface roughnesses in a state that the graphite film was not interposed. The measurement value of this time was represented as x. The measurement conditions are as described above. Next, the thermal resistance was measured for each case by interposing the graphite film in a manner such as shown in Fig. 5. The measurement value of this time was represented as y. However, the thermal resistances measured by this method were values including the thermal resistances between 5a-5b and between 5b-5c (upper and lower two sites, respectively, with a sum of four sites), and were not values showing only the thermal resistances between 5c-5d-5c to be measured in the present invention. In order to calculate the thermal resistances between 5c-5d-5c, it was necessary to estimate the thermal resistances between 5a-5b and between 5b-5c from the measurement values and to subtract the estimated values from the total measured values. For that purpose, the thermal resistances between 6a-6b and between 6b-6c were measured by a method shown in Fig. 6. The value of this time was represented as z. Here, in Fig. 6, the reference numerals 6a, 6b, and 6c denote the rod for measuring thermal resistance, the silicone grease, and the copper foil having mirror-surface, respectively.

The value measured by this method was subtracted from the thermal resistance measured by the method of Fig. 5, that is, the value of y - z was regarded as the thermal resistance to be determined. By comparing the value of x - z and the value of y - z, the effect of the TIM made of the graphite film of the present invention can be estimated. Such a method involved a certain number of presuppositions and was not a method of directly measuring the thermal resistance of the TIM itself; however, this was inferior to in accuracy and was sufficient for the evaluation of the practical properties of the TIM.

### (5) Preparation of samples used in Examples and Comparative Examples

Hereafter, a standard method of fabricating 10 kinds of graphite films having different thicknesses used in the Examples and the Comparative Examples is described.

A curing agent made of 20 g of acetic anhydride and 10 g of isoquinoline was mixed with 100 g of a 18 wt% DMF solution of a polyamide acid prepared from pyromellitic acid dianhydride, 4,4' -diaminodiphenyl ether, and p-phenylenediamine (4/3/1 in a molar ratio) and stirred. After defoaming by centrifugal separation, the mixture was cast and applied onto an aluminum foil. The processes from the stirring till the defoaming were carried out while cooling to 0°C. This laminate of the aluminum foil and the polyamide acid solution was heated at 120 °C for 150 seconds, so as to obtain a gel film having a self-supporting property. This gel film was peeled off from the aluminum foil and fixed to a frame. This gel film was heated at 300 °C, 400 °C, and 500 °C each for 30 seconds, so as to produce polyimide films having an average linear expansion coefficient of 1.6 × 10⁻⁵ cm/cm/°C at 100 to 200 °C, having a birefringence index of 0.14, and ten kinds of polyimide films having different thicknesses were prepared.

The obtained polyimide film was heated up to 1000 °C at a heating rate of 10 °C/minute in a nitrogen gas with use of an electric furnace and held at 1000 °C for one hour to perform a preliminary treatment. Next, the obtained carbonized film was interposed between spacers made of a graphite fiber felt with Ra of 5 µm and further, these were placed between graphite blocks subjected to surface polishing and set in a graphite heater furnace. The temperature was raised up to a maximum treatment temperature (HTT) at a heating rate of 20 °C/minute, and the maximum temperature was held for 10 minutes. Thereafter, the temperature was lowered at a cooling rate of 40 °C/minute. The graphitization treatment was carried out in an argon atmosphere. During this, a load of 100 gf/cm² was applied to the sample.

### [Examples 1 to 6]

Six kinds of graphite films (A) to (F) were prepared by the above method. Each of HTT, thickness, thermal conductivity, density of these graphite films is shown below.
(A) HTT: 2900 °C, thickness: 14.6 µm, thermal conductivity of film plane direction: 1810 W/mK, density: 2.0 g/cm³
(B) HTT: 2900 °C, thickness: 7.3 µm, thermal conductivity of film plane direction: 1780 W/mK, density: 2.0 g/cm³
(C) HTT: 2900 °C, thickness: 2.7 µm, thermal conductivity of film plane direction: 1700 W/mK, density: 2.0 g/cm³
(D) HTT: 2900 °C, thickness: 1.0 µm, thermal conductivity of film plane direction: 1700 W/mK, density: 2.0 g/cm³
(E) HTT: 2900 °C, thickness: 0.3 µm, thermal conductivity of film plane direction: 1610 W/mK, density: 1.9 g/cm³
(F) HTT: 2900 °C, thickness: 0.1 µm, thermal conductivity of film plane direction: 1620 W/mK, density: 1.9 g/cm³

A flexible acrylic polymer layer (having a thickness of 1 µm) was formed on both surfaces of the above (A) to (F), as a measurement sample. This sample was interposed between copper foils having a surface roughness: Ra of 0.26 µm and Rz of 1.94 µm, and the thermal resistance was measured. The measurement method was a method described in the aforementioned thermal resistance measurement of the TIM. The results are shown in Table 1.

**[Table 1]**

| | (A) Fluid substance | | | (B) Graphite film | | | Weight ratio | Surface roughness of material | | Thermal resistance | | | Pressure dependency |
|---|---|---|---|---|---|---|---|---|---|---|---|---|---|
| | Material | Thickness of one plane | Density | Sample | Thickness | Density | (A)/(B) | Ra | Rz | R_{0.1} | R_{0.2} | R_{0.5} | (R_{0.1}/R_{0.5}) |
| | | (µm) | (g/cm³) | | (µm) | (g/cm³) | | (µm) | | (°C·cm²/W) | | | |
| Example 1 | Flexible acrylic polymer layer | 1 | 1.2 | A | 14.6 | 2.0 | 0.08 | 0.26 | 1.94 | 0.40 | 0.31 | 0.26 | 1.54 |
| Example 2 | Flexible acrylic polymer layer | 1 | 1.2 | B | 7.3 | 2.0 | 0.16 | 0.26 | 1.94 | 0.18 | 0.15 | 0.13 | 1.38 |
| Example 3 | Flexible acrylic polymer layer | 1 | 1.2 | C | 2.7 | 2.0 | 0.44 | 0.26 | 1.94 | 0.12 | 0.10 | 0.09 | 1.32 |
| Example 4 | Flexible acrylic polymer layer | 1 | 1.2 | D | 1.0 | 2.0 | 1.2 | 0.26 | 1.94 | 0.10 | 0.08 | 0.07 | 1.40 |
| Example 5 | Flexible acrylic polymer layer | 1 | 1.2 | E | 0.3 | 1.9 | 4.2 | 0.26 | 1.94 | 0.07 | 0.06 | 0.06 | 1.17 |
| Example 6 | Flexible acrylic polymer layer | 1 | 1.2 | F | 0.1 | 1.9 | 12.6 | 0.26 | 1.94 | 0.06 | 0.05 | 0.05 | 1.20 |

The thicknesses of the samples (A) to (F) were 0.1 µm to 14.6 µm, and the value of the thermal conductivity in the film plane direction and the value of the density were all within a range of the conditions that the TIM of the present invention including the preferable embodiments should satisfy. The thermal resistances of these samples were 0.05 to 0.4 °C·cm²/W (in the case in which the load was 0.2 MPa), preferably 0.3 °C·cm²/W or less, and an extremely low thermal resistance surpassing the property of a conventional composite TIM was exhibited. Further, the ratio R_{0.1}/R_{0.5} of the thermal resistance (R_{0.1}) when a pressure of 0.1 MPa was applied to the thermal resistance (R_{0.5}) when a pressure of 0.5 MPa was applied was extremely small and was 1.54 times in the largest one among these samples and 1.17 times in the smallest one among these samples.

### [Comparative Examples 1 to 3]

As a control sample, three kinds of graphite films (G) to (I) prepared were fabricated by the above method. Each of HTT, thickness, thermal conductivity, density of these graphite films is shown below. Thicknesses of samples (G) and (H) were out of the range of the present invention in a thicker direction and thickness of sample (I) was out of the range of the present invention in a thinner direction.
(G) HTT: 2900 °C, thickness: 30 µm, thermal conductivity of film plane direction: 1810 W/mK, density: 2.0 g/cm³
(H) HTT: 2900 °C, thickness: 18 µm, thermal conductivity of film plane direction: 1840 W/mK, density: 2.0 g/cm³
(I) HTT: 2900 °C, thickness: 0.06 µm, thermal conductivity of film plane direction: 1580 W/mK, density: 2.0 to 1.8 g/cm³

A flexible acrylic polymer layer (having a thickness of 1 µm) was formed on both surfaces of these three kinds of graphite films, as a comparison sample. This sample was interposed between copper foils having a surface roughness: Ra of 0.26 µm and Rz of 1.94 µm, and the thermal resistance was measured. The thermal resistances are shown in Table 2. In these samples, the thermal resistances were all 0.3 °C·cm²/W or more, and further were 0.4 °C·cm²/W or more (when the load was 0.2 MPa). Also, the R_{0.1}/R_{0.5} was also large except for the sample (I). The R_{0.1}/R_{0.5} of the sample (I) was 1.26 times and showed that the pressure dependency of the thermal resistance was small as a characteristic feature of the TIM of the present invention. However, the thermal resistance was 0.42 °C·cm²/W (when the load was 0.2 MPa), and the thickness of the graphite film was extremely small (thickness of 0.06 µm), so that it was extremely difficult to use the graphite film as a practical TIM.

**[Table 2]**

| | (A) Fluid substance | | | (B) Graphite film | | | Weight ratio | Surface roughness of material | | Thermal resistance | | | Pressure dependency |
|---|---|---|---|---|---|---|---|---|---|---|---|---|---|
| | Material | Thickness of one plane | Density | Sample | Thickness | Density | (A)/(B) | Ra | Rz | R_{0.1} | R_{0.2} | R_{0.5} | (R_{0.1}/R_{0.5}) |
| | | (µm) | (g/cm³) | | (µm) | (g/cm³) | | (µm) | | (°C·cm²/W) | | | |
| Comparative Example 1 | Flexible acrylic polymer | 1 | 1.2 | G | 30 | 2.0 | 0.04 | 0.26 | 1.94 | 0.95 | 0.53 | 0.40 | 2.32 |
| Comparative Example 2 | Flexible acrylic polymer | 1 | 1.2 | H | 18 | 2.0 | 0.07 | 0.26 | 1.94 | 0.55 | 0.42 | 0.30 | 1.83 |
| Comparative Example 3 | Flexible acrylic polymer | 1 | 1.2 | I | 0.06 | 2.0 to 1.8 | - | 0.26 | 1.94 | 0.45 | 0.42 | 0.36 | 1.26 |

### [Examples 8 to 10]

Three kinds of graphite films prepared by changing the highest treatment temperature (HTT) of sample (B) used in the Examples were fabricated. By using an acrylic polymer as a flexible substance, a flexible layer (having a thickness of 10 µm) was formed on both surfaces, and the thermal resistance properties were measured by the same method as in the Examples 1 to 7. The results are shown in Table 3.
(B-2) HTT: 2700 °C, thickness: 7.3 µm, thermal conductivity of film plane direction: 1280 W/mK, density: 2.0 g/cm³
(B-3) HTT: 2600 °C, thickness: 7.3 µm, thermal conductivity of film plane direction: 1080 W/mK, density: 1.9 g/cm³
(B-4) HTT: 2400 °C, thickness: 7.3 µm, thermal conductivity of film plane direction: 580 W/mK, density: 1.7 g/cm³

**[Table 3]**

| | (A) Fluid substance | | | (B) Graphite film | | | Weight ratio | Surface roughness of material | | Thermal resistance | | | Pressure dependency |
|---|---|---|---|---|---|---|---|---|---|---|---|---|---|
| | Material | Thickness of one plane | Density | Sample | Thickness | Density | (A)/(B) | Ra | Rz | R_{0.1} | R_{0.2} | R_{0.5} | (R_{0.1}/R_{0.5}) |
| | | (µm) | (g/cm³) | | (µm) | (g/cm³) | | (µm) | | (°C·cm²/W) | | | |
| Example 8 | Acrylic polymer layer | 10 | 1.2 | B-2 | 7.3 | 2.0 | 1.64 | 0.26 | 1.94 | 0.26 | 0.20 | 0.17 | 1.53 |
| Example 9 | Acrylic polymer layer | 10 | 1.2 | B-3 | 7.3 | 1.9 | 1.73 | 0.26 | 1.94 | 0.34 | 0.26 | 0.21 | 1.60 |
| Example 10 | Acrylic polymer layer | 10 | 1.2 | B-4 | 7.3 | 1.7 | 1.93 | 0.26 | 1.94 | 0.43 | 0.30 | 0.25 | 1.72 |

From these results, the thermal conductivity of the graphite film in the film plane direction had a large influence on the TIM properties and in order to achieve low thermal resistance properties, the thermal conductivity in the film plane direction was preferably 500 W/mK or more, and it was preferable to treat the polymer film at a temperature of 2400 °C or higher as a temperature for fabricating the graphite film.

### [Examples 11 to 16]

By using the graphite film (E), 6 kinds of TIMs in which the kind of the flexible layer and the thickness thereof were changed were fabricated. Table 4 shows the results of measuring the thermal resistance properties by the same method as in the aforementioned Examples. From these results, the type of the flexible substance gives little influence on the thermal resistance properties, and the weight ratio of the flexible substance to the graphite film (flexible substance/graphite film) was preferably within a range of 0.08 to 25 (preferably 1 to 20).

**[Table 4]**

| | (A) Fluid substance | | | (B) Graphite film | | | Weight ratio | Surface roughness of material | | Thermal resistance | | | Pressure dependency |
|---|---|---|---|---|---|---|---|---|---|---|---|---|---|
| | Material | Total thickness | Density | Sample | Thickness | Density | (A)/(B) | Ra | Rz | R_{0.1} | R_{0.2} | R_{0.5} | (R_{0.1}/R_{0.5}) |
| | | (µm) | (g/cm³) | | (µm) | (g/cm³) | | (µm) | | (°C·cm²/W) | | | |
| Example 11 | Silicone polymer layer | 0.8 | 1.2 | E | 0.3 | 1.9 | 1.68 | 0.26 | 1.94 | 0.08 | 0.07 | 0.07 | 1.14 |
| Example 12 | Epoxy polymer layer | 0.8 | 1.2 | E | 0.3 | 1.9 | 1.68 | 0.26 | 1.94 | 0.08 | 0.07 | 0.07 | 1.14 |
| Example 13 | Acrylic polymer layer | 0.4 | 1.2 | E | 0.3 | 1.9 | 0.84 | 0.26 | 1.94 | 0.09 | 0.08 | 0.07 | 1.28 |
| Example 14 | Acrylic polymer layer | 0.8 | 1.2 | E | 0.3 | 1.9 | 1.68 | 0.26 | 1.94 | 0.07 | 0.06 | 0.06 | 1.17 |
| Example 15 | Acrylic polymer layer | 4.0 | 1.2 | E | 0.3 | 1.9 | 8.4 | 0.26 | 1.94 | 0.17 | 0.15 | 0.13 | 1.33 |
| Example 16 | Acrylic polymer layer | 8.0 | 1.2 | E | 0.3 | 1.9 | 16.8 | 0.26 | 1.94 | 0.35 | 0.27 | 0.21 | 1.67 |

### [Examples 17 to 21]

By using a flexible acrylic polymer as a flexible substance, a flexible layer having a thickness of 5 µm was formed on both surfaces of the graphite film (E), and the thermal resistance properties were measured by preparing five kinds of copper foils having different surface roughnesses. The results are shown in Table 5.

**[Table 5]**

| | (A) Fluid substance | | | (B) Graphite film | | | Weight ratio | Surface roughness of material | | Thermal resistance | | | Pressure dependency |
|---|---|---|---|---|---|---|---|---|---|---|---|---|---|
| | Material | Thickness of one plane | Density | Sample | Thickness | Density | (A)/(B) | Ra | Rz | R_{0.1} | R_{0.2} | R_{0.5} | (R_{0.1}/R_{0.5}) |
| | | (µm) | (g/cm³) | | (µm) | (g/cm³) | | (µm) | | (°C·cm²/W) | | | |
| Example 17 | Flexible acrylic polymer layer | 5 | 1.2 | E | 0.3 | 1.9 | 21.1 | 0.20 | 1.13 | 0.07 | 0.06 | 0.06 | 1.17 |
| Example 18 | Flexible acrylic polymer layer | 5 | 1.2 | E | 0.3 | 1.9 | 21.1 | 0.54 | 2.71 | 0.10 | 0.08 | 0.08 | 1.25 |
| Example 19 | Flexible acrylic polymer layer | 5 | 1.2 | E | 0.3 | 1.9 | 21.1 | 1.22 | 3.57 | 0.19 | 0.16 | 0.14 | 1.36 |
| Example 20 | Flexible acrylic polymer layer | 5 | 1.2 | E | 0.3 | 1.9 | 21.1 | 1.86 | 4.62 | 0.30 | 0.24 | 0.20 | 1.50 |
| Example 21 | Flexible acrylic polymer layer | 5 | 1.2 | E | 0.3 | 1.9 | 21.1 | 2.86 | 8.62 | 0.55 | 0.38 | 0.31 | 1.78 |

From these results, the TIM of the present invention can be used between materials having unevenness in a wide range, and an excellent thermal resistance property of 0.4 °C·cm²/W or less can be achieved between such materials.

### [Examples 22 to 25]

The graphite film (C) was immersed into a silicone oil, and the surface of the graphite film was wiped off with a gauze. The weight ratio was changed by changing the degree of wiping off. The weight ratio of silicone oil/graphite film was about 2 in the Examples 22 to 24, and was about 4 in the Example 25. By using these, the thermal resistance properties were measured using three kinds of copper foils having different surface roughnesses. The measurement results are shown in Table 6. From these results, even when a fluid substance such as a silicone oil is used, the TIM can be used between materials having unevenness, and an excellent thermal resistance property of 0.4 °C·cm²/W or less can be achieved between such materials.

**[Table 6]**

| | (A) Fluid substance | (B) Graphite film | | | Weight ratio | Surface roughness of material | | Thermal resistance | | | Pressure dependency |
|---|---|---|---|---|---|---|---|---|---|---|---|
| | Material | Sample | Thickness | Density | (A)/(B) | Ra | Rz | R_{0.1} | R_{0.2} | R_{0.5} | (R_{0.1}/R_{0.5}) |
| | | | (µm) | (g/cm³) | | (µm) | | (°C·cm²/W) | | | |
| Example 22 | Silicone oil | C | 2.7 | 2.0 | About 2 | 0.20 | 1.13 | 0.13 | 0.12 | 0.10 | 1.30 |
| Example 23 | Silicone oil | C | 2.7 | 2.0 | About 2 | 0.54 | 2.71 | 0.15 | 0.13 | 0.11 | 1.36 |
| Example 24 | Silicone oil | C | 2.7 | 2.0 | About 2 | 1.22 | 3.57 | 0.25 | 0.21 | 0.17 | 1.47 |
| Example 25 | Silicone oil | C | 2.7 | 2.0 | About 4 | 0.20 | 1.13 | 0.15 | 0.12 | 0.10 | 1.50 |

### EXPLANATION OF NUMERICAL REFERENCE

3a fluid substance (flexible substance)
3b graphite film
4a first material
4b thermal interface material
4c second material
5a rod for measuring thermal resistance
5b silicone grease
5c copper foil having given unevenness on one plane
5d thermal interface material
6a rod for measuring thermal resistance
6b silicone grease
6c copper foil having mirror surface

## Claims

1. A thermal interface material for transferring heat by interposing between two materials, wherein the thermal interface material comprises a graphite film and a fluid substance, the graphite film has a thickness of 100 nm to 15 µm, and a weight ratio of the fluid substance to the graphite film is 0.08 to 25.

2. The thermal interface material according to claim 1, wherein the graphite film has a density of 1.20 g/cm³ to 2.26 g/cm³, and a thermal conductivity of 500 W/mK to 2000 W/mK in a film plane direction.

3. The thermal interface material according to claim 1 or 2, wherein the fluid substance is a solid at 20 °C, the fluid substance has a deformation property on a load of 0.5 MPa at 20 °C, and a thickness of the fluid substance after the deformation is 1/2 or less a thickness of the fluid substance before the deformation.

4. The thermal interface material according to claim 1 or 2, wherein the fluid substance is a liquid at 20 °C, and the fluid substance has a boiling point of 150 °C or more.

5. The thermal interface material according to any one of claims 1 to 3, wherein the fluid substance comprises at least one selected from an acrylic polymer, an epoxy resin, and a silicone polymer.

6. A method for thermally coupling materials with the thermal interface material according to any one of claims 1 to 5, wherein a thermal resistance of the thermal interface material is 0.4 °C·cm²/W or less on a load of 0.2 MPa.

7. A method for thermally coupling materials with the thermal interface material according to any one of claims 1 to 5, wherein a ratio of a thermal resistance R_{0.1} on a load of 0.1 MPa to a thermal resistance R_{0.5} on a load of 0.5 MPa of the thermal interface material is 1.0 to 1.8.

8. A method for thermally coupling materials with a thermal interface material for transferring heat from a first material to a second material, wherein the fluid substance contacts with at least one of the first material and the second material, the graphite film contacts with the fluid substance, the graphite film has a thickness of 100 nm to 15 µm, and a weight ratio of the fluid substance to the graphite film is 0.08 to 25.

9. A method for preparing the thermal interface material according to any one of claims 1 to 5, comprising carbonizing a polymer film to form a carbonized film, and graphitizing the carbonized film to form a graphite film.

10. The method according to claim 9, wherein the polymer film comprises a condensed aromatic polymer.

11. The method according to claim 10, comprising carbonizing and graphitizing the polymer film containing the condensed aromatic polymer at a temperature of 2400 °C or more, wherein the polymer film containing the condensed aromatic polymer has a thickness of 200 nm to 40 µm and the condensed aromatic polymer comprises an aromatic polyimide.
